# EUROPEAN PATENT SPECIFICATION

(11) **EP 0 330 512 B1**
(45) Date of publication and mention of the grant of the patent: **23.07.1997**
(21) Application number: 89301889.5
(22) Date of filing: 24.02.1989
(51) Int. Cl.: H01L 23/50, H01L 21/48

(54) **Producing electronic components with the aid of lead frames**
Herstellung elektronischer Bauelemente mit Hilfe von Leiterrahmen
La fabrication de composants électroniques à l'aide de cadres de conducteurs

(30) Priority: 24.02.1988 JP 42815/88
(43) Date of publication of application: 30.08.1989
(73) Proprietor: FUJITSU LIMITED, Kawasaki-shi, Kanagawa 211 (JP)
(72) Inventor: Suzuki, Toshiaki, Aizuwakamatsu-shi Fukushima 965 (JP); Murakami, Yoji, Aizuwakamatsu-shi Fukushima 965 (JP); Kobayashi, Masao, Aizuwakamatsu-shi Fukushima 965 (JP); Yamauchi, Osamu, Aizuwakamatsu-shi Fukushima 965 (JP)
(74) Representative: Fane, Christopher Robin King

(56) References cited:
- GB-A- 2 027 990
- JP-A-61 279 159
- US-A- 4 012 766
- US-A- 4 214 364
- US-A- 4 477 827
- US-A- 4 721 993
- US-A- 4 725 692
- PATENT ABSTRACTS OF JAPAN, vol. 13, no. 531 (E-851) 28 November 1989; & JP-A-01 216 564
- PATENT ABSTRACTS OF JAPAN, vol. 13, no. 404 (E-817) 7 September 1989; & JP-A-01 145 838
- PATENT ABSTRACTS OF JAPAN, vol. 12, no. 407 (E-675) 27 October 1988; & JP-A-63 148 670
- PATENT ABSTRACTS OF JAPAN, vol. 12, no. 9 (E-572) 12 January 1988; & JP-A-62 169 334
- PATENT ABSTRACTS OF JAPAN, vol. 12, no. 221 (E-625) 23 June 1988; & JP-A-63 015 454
- PATENT ABSTRACTS OF JAPAN, vol. 6, no. 64 (E-103) 23 April 1982; & JP-A-57 005 352

## Description

The present invention relates to producing electronic components with the aid of lead frames.

A lead frame may be used in the production of an electronic component, and various lead frames can be provided to suit different types of electronic component to be produced.

A lead frame used to produce an electronic component having a "quad type" package may comprise an outer frame portion surrounding a generally rectangular central opening, and a rectangular mount portion which is disposed within the central opening of the outer frame portion and on which an electronic element such as an integrated circuit (IC) chip can be mounted. The rectangular mount portion may be supported by the outer frame portion by a bar element extending therebetween. The lead frame also comprises four lead element arrays disposed respectively along the four sides of the rectangular mount portion, outer portions of which arrays may he integrally connected to the outer frame portion, so that the lead elements included in each array extend from an inner edge of the outer frame portion toward the corresponding edge of the rectangular mount portion. In such a quad type electronic component, especially one having a quad flat package, the IC chip mounted on the rectangular mount portion may be sealed within a suitable synthetic resin, such as an epoxy resin, by by means of a split mould in which the mount portion and the IC chip mounted thereon are enclosed. Accordingly, the lead frame may further comprise respective dam-bar portions forming a rectangle surrounding the rectangular mount portion and integrally formed with the respective lead element arrays in such a manner that each of the four sides of the rectangular dam-bar arrangement extends transversely between the lead elements included in a corresponding array. Thus, adjacent lead elements in each array are joined to one another by a dam-bar portion. When the mounted IC chip is encapsulated within the resin, the dam-bar portions cooperate with the split mold to prevent the resin from leaking out through clearance between the adjacent lead elements. This lead frame arrangement may be formed from a thin Ni-Fe alloy or Cu alloy plate by a photoetching process or mechanical punching work.

In the production of a quad type electronic component using a lead frame as mentioned above, the IC chip may be mounted on the mount portion of the lead frame by using a silver or gold paste, and then a wire bonding process can be performed to establish electrical connections between the IC chip and the lead elements. After the wire bonding step, the mount portion with the IC chip is enclosed by the split mold so that the dam-bar portions cooperate with the split mold, the resin is then introduced into the mold, and thus the IC chip, the mount portion thereof, and the inner end portions of the lead elements are sealed in the molded resin. Thereafter, the dam-bar portions are cut to release the lead elements from the dam-bar connections, and then the lead frame with the sealed IC chip is subjected to an electrolytic plating process to coat the lead elements with a thin Sn-Pb alloy layer. After the plating process, the lead elements are trimmed and bent by press-cutting in such a manner that the lead elements are detached from the outer frame portion of the lead frame and are bent downward with respect to the mount portion thereof, and as a result, a quad type electronic component (QFP) is obtained.

The trimming/bending process is performed in a press-cutting machine comprising a die assembly and a movable assembly associated therewith. In particular, the die assembly includes a bending die having a rectangular recess formed on the top face thereof and four ridge portions formed along the four sides thereof, and a cutting die surrounding the bending die and having four cutting edges disposed in parallel with the four ridge portions. Each of the cutting edges is spaced apart from the corresponding ridge portion and is flush with the top thereof. The movable assembly includes a knockout having a rectangular recess formed on the lower end face thereof and four edge portions formed along the four sides thereof, a stripper surrounding the knockout while maintaining a space therebetween, and the punch disposed in the space between the knockout and the stripper. The knockout and the stripper cooperate with the bending die and the cutting die, respectively, and the punch cooperates with both the bending and cutting dies.

In the trimming/bending process, the lead frame with the sealed IC chip is positioned on the bending die so that the sealed IC chip, i.e. the molded portion, is received by the rectangular recess thereof, the lead elements included in each array extending to bridge the space between the corresponding ridge portion and the corresponding cutting edge. Then, the knockout and the stripper are lowered until engaged with the lead elements and cooperate with the bending die and the cutting die, respectively, so that the lead elements are clamped between the edge portions of the knockout and the ridge portions of the bending die and between the stripper and the cutting die, the molded portion of the lead frame being accommodated within a cavity formed by both the rectangular recesses of the knockout and the bending die. The punch is then lowered until engaged with the lead elements, and cooperates with the bending die and the cutting die, whereby the lead elements are deformed downward to conform with an outside profile of the ridge portions of the bending die, while being detached from the outside frame portion of the lead frame.

The above method of producing electronic components possesses a defect in the trimming/bending process. In particular, during the bending of the lead elements, the plating layers thereof are contacted by the punch and thus may be partially scraped from the surface of the lead elements. Also, the scraped fragments of the plating layers may cause short circuits among leads of the finished electronic components that are very close to one another.

To alleviate the problem due to such abrasion of plating layers of the lead elements by the punch, in another method the pre-trimmed lead elements are bent by a press machine arranged so that the abrasive action can be eliminated during the bending process. In one type of such a press machine, a cam mechanism is used to impart a cam motion to the punch, to avoid the abrasive action of the punch against the lead elements during the bending process. In another type of press machine, the punch is provided with rollers which impart a bending action to the lead elements, whereby the abrasive action can be eliminated during the bending process. These press machines however are both complicated and expensive.

If an attempt is made to solve the problem mentioned above by performing the plating process after the trimming/bending process, a difficulty arises in that during the electrolytic-plating process the trimmed and bent leads must be connected to terminals for providing an electric current and the formation of uniform plating layers on the trimmed and bent leads may be inhibited at the regions of direct connection to the trimmed and bent leads.

It is desirable, therefore, to provide a method of producing an electronic component, using a lead frame, wherein plating of lead elements of the lead frame can be successfully performed after bending of those elements.

JP-A-62 169 334 discloses a lead frame having the features of the preamble of accompanying claim 1. The expandable tie bar elements are in the form of intermediate connecting parts linking the common tie bars of the lead element arrays to an outer frame. These connecting parts are readily deformed in the planar direction to absorb thermal stress.

JP-A-61 279 159 discloses a lead frame in which the connecting parts between the lead element arrays and the outer frame cross the bending lines of the lead element arrays and are therefore bent in the same way as the lead elements during a bending process.

US-A-4 725 692 discloses a lead frame in which the connecting parts between the lead element arrays and the outer frame form angular portions between the outer frame and outer tie bars of the lead element arrays.

US-A-4 477 827 discloses a method of producing an electronic component using a lead frame, in which the lead elements can be bent prior to mounting the electronic element.

US-A-4 214 364 discloses a production method for an electronic component, in which the lead elements are tin plated prior to being bent.

US-A-4 721 993 discloses a lead frame similar to that of JP-A-62 169 334. The purpose of the expandable tie bar portions is to reduce stress in the leads and reduce thermal dissipation during inner lead bonding.

According to a first aspect of the present invention, there is provided a lead frame for use in production of an electric component, comprising:
an outer frame portion having a central opening formed therein and defining interior sides of the outer frame portion;
a mount portion for mounting an electronic element thereon, supported by said outer frame portion and disposed within the central opening thereof with the exterior sides of the mount portion in spaced relationship from the corresponding interior sides of said outer frame portion;
at least one lead element array comprising plural lead elements, disposed along an associated one of said exterior sides of said mount portion and a common tie bar element associated with each said lead element array, said common tie bar element being integrated with the plural lead elements of said lead element array and thereby connecting together all of said plural lead elements thereof; and
at least two of said expandable tie bar elements are provided for each lead element array and are symmetrically disposed with respect to the center of each lead element array, said expandable tie bar elements associated with each said lead element array, extending between and interconnecting said outer frame portion, and said associated lead element array to thereby support said lead element array on said outer frame portion, each expandable tie bar element being connected at one end thereof to said outer frame portion and at the other end thereof to said associated lead element array, and including a shaped portion which can be expanded by deformation thereof; characterised in that said shaped portion of each expandable tie bar element being provided with a double U-turn portion so as to be expandable in a direction, and to an extent, allowing such a bending of the lead elements that after bending, the outer ends of the lead elements extend in a plane different from but parallel to the main plane of the lead frame, without detaching the lead elements from said outer frame portion.

The common tie bar element is preferably integrated with the outer ends of the lead elements included in the lead element array. In this case, each of the expandable tie bar elements is connected to the outside frame portion at one end thereof and to the common tie bar element at the other end thereof.

Alternatively, the expandable tie bar elements connected to one array may be directly connected between on the one hand the outside frame portion and on the other hand the respective lead elements at opposite ends of the array concerned.

According to a second aspect of the invention, there is provided a method of producing an electronic component using a lead frame of the above type, comprising the steps of: mounting an electronic element on the mount portion of said lead frame;
establishing electrical connections between respective terminals on the mounted electronic element and the inner ends of lead elements of said lead element array;
sealing the mount portion of said lead frame, the electronic element mounted thereon, and the inner ends of the lead elements of said lead element array with a suitable material;
bending the outer portions of the lead elements, which extend from the sealed portion of said lead element array, out of the main plane of the lead frame by using a press, the shaped portion of each expandable tie bar element being expanded to maintain the connection between the lead element array and said outer frame portion;
performing an electrolytic-plating process to coat the bent lead elements of said lead frame with a suitable alloy layer by applying an electric current to the bent lead elements in said lead element array through the intermediary of each expanded tie bar element; and
trimming the bent and plated lead elements of said lead element array.

In this production method, the bending step may be also performed before the mounting step. In this case, the outer portions of the lead elements, which are bent in the bending step, are portions which will extend from the sealed portion of the lead element array after the sealing step.

Reference will now be made, by way of example, to the accompanying drawings in which:
Figure 1 is a detailed plan view of a part of a lead frame strip including two lead frames at different respective stages of a production process according to an embodiment of the present invention;
Figure 2 is a plan view showing lead frames at different respective stages of the production process according to a further embodiment of the present invention;
Figure 3 is a flow chart for explaining a method of producing an electronic component using the lead frame strip of Fig. 1;
Figures 4A and 48 are schematic perspective views showing a part of the lead frame of Figure 1, for explaining a bending process used in the production method concerned;
Figures 5A and 5B are schematic sectional views partially showing a bending machine in which the bending process of Figure 4 is performed;
Figure 6 is a perspective view showing a finished quad type electronic component produced by means of an embodiment of the present invention; and
Figure 7 is a modified version of the flow chart of Fig. 3.

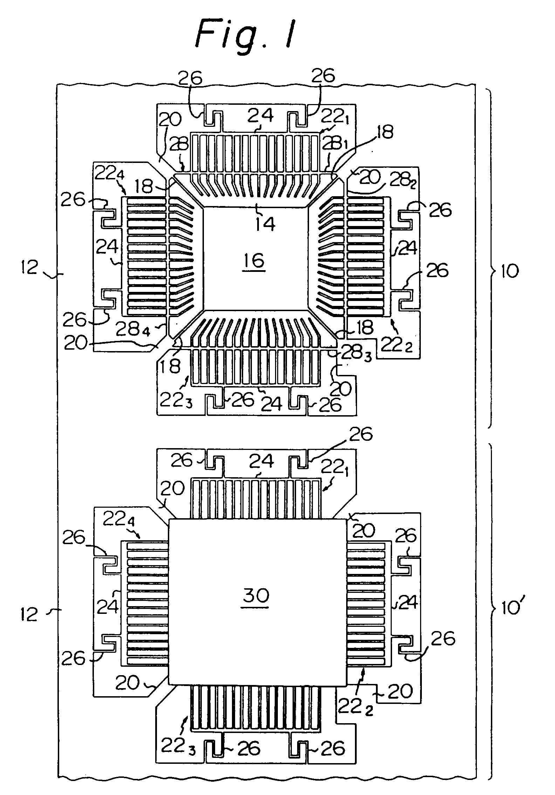

Figure 1 shows a part of a lead frame strip in which lead frames are continuously formed, and which may be obtained from a thin Ni-Fe alloy or Cu alloy blank by a photoetching process or mechanical punching. The lead frame per se, generally designated by a reference numeral 10, comprises an outside frame portion or cradle portion 12 having a central opening 14 formed therein, and a rectangular mount portion 16 disposed within the central opening 14 for mounting an electronic element such as an integrated circuit (IC) chip thereon. The mount portion 16 is supported by the cradle portion 12 through the intermediary of four tie bar elements 18, each of which is connected at one end thereof to one of tongue elements 20, extending from inner corners of the cradle portion 12, and at the other end thereof to the corresponding corner of the mount portion 16.

The lead frame 10 also comprises four lead element arrays 22₁ , 22₂ , 22₃ and 22₄ disposed in the opening 14 along four sides of the mount portion 16, respectively, as shown in Fig. 1. The lead elements included in each array 22₁ , 22₂ , 22₃ , 22₄ are disposed substantially parallel to one another and extend perpendicularly to the respective adjacent sides of the mount portion 16, and are connected to each other by a common tie bar element 24 integrated with the outer ends thereof. Alternatively, the common tie bar element may transversely extend through the lead elements in each array at the inside of the outer ends thereof.

In the lead frame 10 the lead elements included in each array are supported by the cradle portion 12 through the intermediary of at least two expandable tie bar elements 26, each of which is connected to the cradle portion 12 at one end thereof and to the corresponding common tie bar element 24 at the other end thereof. As shown in Fig. 1, each of the tie bar elements 26 has a double U-turn shape (substantially an S-shape) and thus can be expanded by deformation (straightening) of the shaped portion thereof. The expandable tie bar elements may have another shape such as zigzag form. Preferably, as shown in Fig. 1, the two expandable tie bar elements 26 are symmetrically disposed with respect to the center of each lead element array 22₁ , 22₂ , 22₃ , 24₄ , for the reasons mentioned hereinafter.

The lead frame 10 further comprises a rectangular dam-bar element 28 surrounding the mount portion 16, and integrally formed with the lead elements in such a manner that each of the four sides 28₁ , 28₂ , 28₃ and 28₄ of the rectangular dam-bar element 28 transversely extends through the lead elements included in the corresponding array 22₁ , 22₂ , 22₃ , 22₄. In particular, the lead elements included in each array are connected to each other by one of the four sides 28₁ , 28₂ , 28₃ and 28₄ of the dam-bar element 28, each side being connected to the corresponding two tongue elements 20 at the ends thereof. The rectangular dam-bar element 28 cooperates with a split mold (not shown) by which the mount portion 16 and an electronic element (i.e. IC chip) mounted thereon, and the inner end portions of the lead elements are enclosed when sealed with a suitable synthetic resin such as epoxy resin, whereby the resin introduced into the split mold is prevented from leaking out through clearances between the lead elements. In Fig. 1, a second lead frame, generally designated by a reference numeral 10', is shown at a later stage in the manufacturing process having a sealed or molded portion 30 in which the mount portion 16 and the electronic element mounted thereon, and the inner end portions of the lead elements are encapuslated. When comparing the lead frame 10 with the lead frame 10', it can be easily be understood that the perimeter of the molded portion 30 coincides with the rectangular dam-bar element 28. Note, in the lead element arrays 22 of the frame 10', the dam-bar element 28 has been cut so that the lead elements are detached from the dam-bar connections.

In the lead frame arrangements, although the rectangular mount portion 16 is supported by the cradle portion 12 through the intermediary of the tie bar elements 18, this support may be made by connecting the mount portion to a part of the lead elements.

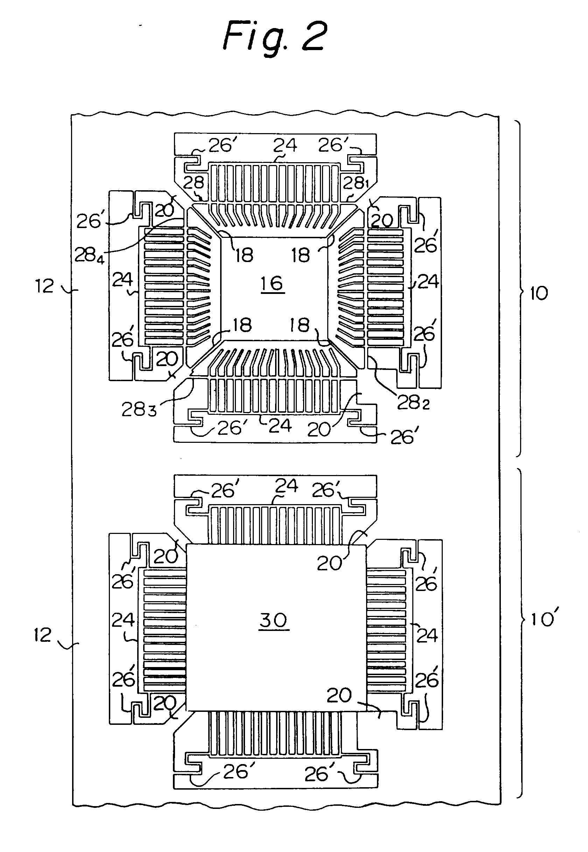

Figure 2 shows a modification to the embodiments of Fig. 1, in which the expandable tie bar elements 26' for supporting the lead elements in each array from the cradle portion 12 are not connected to the common tie bar element 24 but are connected to the outermost lead elements in each array.

A method of producing a quad type electronic component using the lead frame strip of Fig. 1 will be now explained by way of example:

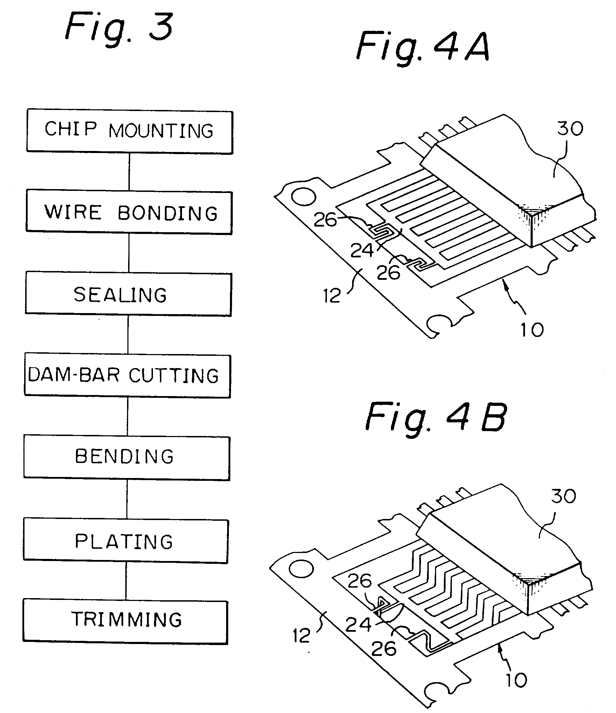

The production method may be executed in accordance with a flow chart of Fig. 3, which comprises the steps of chip bonding, wire bonding, sealing, dam-bar cutting, bending, electrolytic-plating, and trimming.

In the chip mounting step, an IC chip is mounted on the mount portion 16 of the lead frame 10 by a suitable adhesive paste such as a silver or gold paste. This bonding process is performed in a well-known chip mounting machine, i.e., a so-called -"die bonder".

In the wire-bonding step, electrical connections between the mounted IC chip and the lead elements of the lead frame 10 are established by using a gold wire. This wire bonding process may be performed in a well-known wire bonding machine.

In the sealing step, the mount portion 16 and the IC chip mounted thereon, and the inner end portions of the lead elements are enclosed by a split mould, and then a suitable synthetic resin, such as an epoxy resin, is introduced into the split mold, whereby the IC chip and the mount portion 16 thereof, and the inner end portions of the lead elements are sealed in a molded resin portion 30. As mentioned above, the split mould cooperates with the dam-bar element 28 of the lead frame 10 to prevent the resin from leaking out through the clearance between the lead elements. This sealing or molding process may be performed in a well-known molding machine of the type including a split mold.

In the dam-bar cutting step, the dam-bar element is cut by a comb-like cutter having cutting edges arrayed at the same pitch as the lead elements, whereby the dam-bar connections between the lead elements are severed. This dam-bar cutting process may be performed by a well-known dam-bar cutting machine including such a comb-like cutter.

In the bending step, the lead elements extend from the four sides of the molded portion 30 are bent so as to extend downwardly with respect to the molded portion 30 of the lead frame. Note, the bending of the lead elements can be carried out without detaching them from the cradle portion 12 of the lead frame.

In other words, although the lead elements of the lead frame are bent as mentioned above, the connection between the lead elements and the cradle portion 12 is maintained by means of the expandable tie bar elements 26. This can be easily understood by reference to Figures 4A and 4B, wherein Fig. 4A shows a part of the lead frame with the sealed or molded portion 30, in which the lead elements are shown before the bending process, and Fig. 4B shows the same part as in Fig. 4A, but after the bending process. As is apparent from Figs. 4A and 4B, while the lead elements are bent, the expandable tie bar elements 26 are elongated by distortion of the double U-turn portions thereof, so that the lead elements can be bent without disconnecting them from the cradle portion 12 of the lead frame.

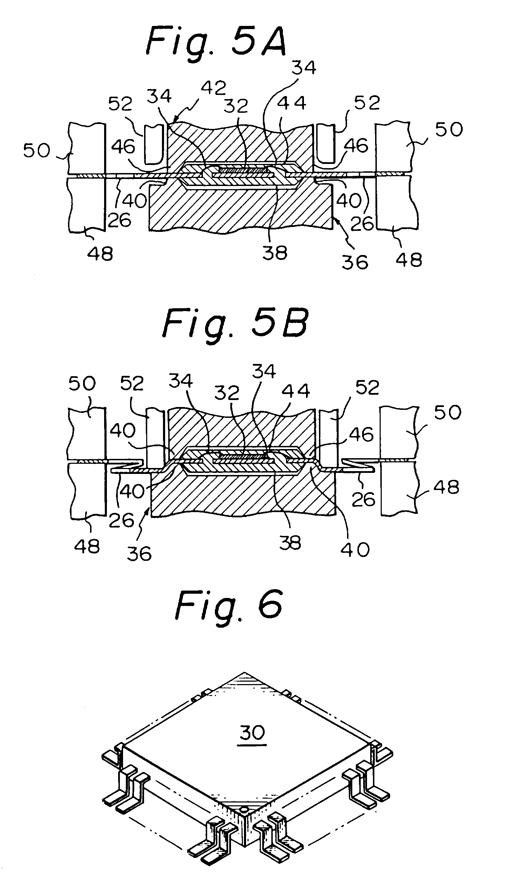

The bending process may be performed in a bending machine as partially and schematically shown in Figures 5A and 5B. In Figs. 5A and 5B, the lead frame having the moulded portion is shown set in the bending machine, and reference numerals 32 and 34 denote the IC chip and the bonded wire, respectively, which are enclosed in the moulded portion. The bending machine comprises a bending die 36 having a rectangular recess 38 formed on the top face thereof and four ridge portions 40 (only two of which are shown in Figs. 5A and 5B) formed along the four sides of the rectangular recess 38, and a knockout 42 having a rectangular recess 44 formed on the lower end face thereof and four edge portions 46 (only two of which are shown in Figs. 5A and 5B) formed along the four sides of the rectangular recess 44. The bending die 36 and the knockout 42 cooperate during the bending process, as mentioned hereinafter. The bending machine also comprises a lower clamp member 48 surrounding the bending die 36 while maintaining a space therebetween, and an upper clamp member 50 which cooperates with the lower clamp member 48, and surrounding the knockout 42 while maintaining a space therebetween. As is apparent from Figs. 5A and 5B, a clamping face or top face of the lower clamp member 48 is flush with the tops of the ridge portions 40. The bending machine further comprises a punch 50 disposed in the space between the knockout 42 and the upper clamp member 50, and cooperating with outside profiles of the ridge portions 40 of the bending die 38 during the bending process, as mentioned hereinafter.

In the bending process, the lead frame with the sealed IC chip is positioned on the bending die 36 so that the sealed IC chip, i.e., the molded portion 30, is received in the rectangular recess 38 of the bending die 36; the lead elements and the cradle portion 12 of the lead frame resting on the ridge portions 40 of the bending die 36 and on the clamp face of the lower clamp member 48, respectively. Then the knockout 42 and the upper clamp member 50 are lowered until engaged with the lead elements and the cradle portion 12 of the lead frame, and cooperate with the bending die 36 and the lower clamp member 48, respectively, so that the lead elements and cradle portion 12 are clamped between the edge portions 46 of the knockout 42 and the ridge portions 40 of the bending die 36 and between the upper and lower clamp members 50 and 48, respectively (Fig. 5A), the molded portion 30 of the lead frame being accommodated within a cavity formed by the rectangular recesses 44 and 38 of the knockout 42 and the bending die 36. Consecutively, the punch 52 is then lowered until engaged with the lead elements, and cooperates with the outside profile of the ridge portions 40 of the bending die 36, whereby the lead elements are deformed downward to conform with the outside profile of the ridge portions 40, but the connection between the lead elements and the cradle portion 12 is maintained due to the expansion of the expandable tie bar elements 26, as shown in Fig. 5B. Note, since the two expandable tie bar elements 26 are symmetrically disposed with respect to the center of each lead element array 22₁ , 22₂ , 22₃ , 22₄ , it is possible to avoid warping of the bent lead elements in each array, which may be caused by a resilient restoration force of the expanded tie bar elements 26.

Preferably, the chip mounting, wire bonding, sealing, dam-bar cutting, and bending processes as mentioned above are performed in a working line along which the working stages, namely, the chip mounting, wire bonding, sealing, dam-bar cutting, and bending machines are positioned. With this arrangement, it is possible to efficiently perform the processes by passing the lead frame strip of Fig. 1 through the working line.

In the plating step, the lead frames included in the lead frame strip and subjected to the above-mentioned processes, are electrolytically plated so that the bent lead elements in each lead frame are coated with a thin Sn-Pb alloy layer. This electrolytic-plating process may be performed with a well-known electrolytic-plating equipment which includes an electrolytic cell holding an electrolyte. During the electrolytic-plating process, the lead frame strip is partially immersed in the electrolyte so that the bent lead elements included therein are completely submerged in the electrolyte, and a portion of the lead frame strip protruding from the electrolyte is connected to a terminal which is connected to an electric source, whereby an electric current is applied to the bent lead elements in each array through the intermediary of the two expanded tie bar elements 26. Note, the symmetrical arrangement of the tie bar elements 26 contributes to a uniform application of the electric current to the bent lead elements in each array 22₁ , 22₂ , 22₃ , 22₄ , whereby the plating layer can be uniformly formed thereon. In this sense, the embodiment of Fig. 1 is preferable to that of Fig. 2 in that the electric current can be more uniformly applied to the bent lead elements in each array.

In the trimming step, the lead elements in the four arrays 22₁ , 22₂ , 22₃ and 22₄ are cut from the common tie bar elements 24, thus completing the production process and producing an electronic component in a quad flat package, as shown in Figure 6. This trimming process may be performed in a well-known trimming machine.

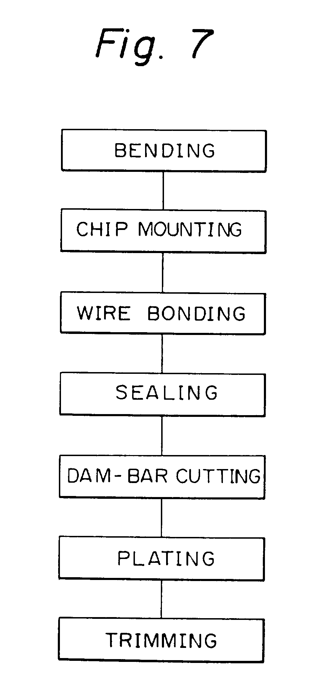

Figure 7 shows a modified flow chart of Fig. 3, in which the bending process is first performed. Note, as long as the bending process is performed before the plating process, the bending step may be incorporated anywhere in the flow chart of Fig. 3.

In the production method as mentioned above, the mounted IC chip may be sealed by using two ceramic plate elements and a glass material having a low melting point. Namely, the mounted IC chip is sandwiched between the two ceramic plate elements which are adhered to each other by the glass material. In this case, of course, the dam-bar element is omitted from the lead frame.

A lead frame used to produce a dual in-line type electronic component (DIP) can be also used in accordance with an embodiment of the present invention, but in this lead frame arrangement, only two lead element arrays are disposed along a pair of opposed sides of the rectangular mount portion.

Furthermore, a lead frame used to produce an electronic component having a single bent lead array can also be used in accordance with an embodiment of the present invention. In this case, only one lead element array is disposed along a side of the mount portion.

## Claims

1. A lead frame (10) for use in production of an electric component, comprising:
an outer frame portion (12) having a central opening formed therein and defining interior sides of the outer frame portion;
a mount portion (16) for mounting an electronic element thereon, supported by said outer frame portion and disposed within the central opening thereof with the exterior sides of the mount portion in spaced relationship from the corresponding interior sides of said outer frame portion;
at least one lead element array (22₁, 22₂, 22₃, 22₄), comprising plural lead elements, disposed along an associated one of said exterior sides of said mount portion and a common tie bar element (24) associated with each said lead element array, said common tie bar element being integrated with the plural lead elements of said lead element array and thereby connecting together all of said plural lead elements thereof; and
at least two of said expandable tie bar elements (26) are provided for each lead element array (22₁, 22₂, 22₃, 22₄) and are symmetrically disposed with respect to the center of each lead element array, said expandable tie bar elements (26) associated with each said lead element array extending between and interconnecting said outer frame portion and said associated lead element array to thereby support said lead element array on said outer frame portion, each expandable tie bar element (26) being connected at one end thereof to said outer frame portion (12) and at the other end thereof to said associated lead element array, and including a shaped portion which can be expanded by deformation thereof;
characterised in that said shaped portion of each expandable tie bar element (26) being provided with a double U-turn portion so as to be expandable in a direction, and to an extent, allowing such a bending of the lead elements that after bending, the outer ends of the lead elements extend in a plane different from but parallel to the main plane of the lead frame, without detaching the lead elements from said outer frame portion (12).

2. A method of producing an electronic component using a lead frame (10) as set forth in claim 1, comprising the steps of:
mounting an electronic element (30) on the mount portion (16) of said lead frame (10);
establishing electrical connections between respective terminals on the mounted electronic element (30) and the inner ends of lead elements of said lead element array (22₁, 22₂, 22₃, 22₄);
sealing the mount portion (16) of said lead frame, the electronic element (30) mounted thereon, and the inner ends of the lead elements of said lead element array with a suitable material;
bending the outer portions of the lead elements, which extend from the sealed portion of said lead element array, out of the main plane of the lead frame by using a press, the shaped portion of each expandable tie bar element (26) being expanded to maintain the connection between the lead element array and said outer frame portion;
performing an electrolytic-plating process to coat the bent lead elements of said lead frame with a suitable alloy layer by applying an electric current to the bent lead elements in said lead element array through the intermediary of each expanded tie bar element (26);
and trimming the bent and plated lead elements of said lead element array.

3. A method as set forth in claim 2, wherein said bending step is performed before said mounting step, said outer portions of the lead elements being portions intended to extend from the sealed portion of said lead element array after said sealing step.

## Revendications

1. Grille de connexion (10) pour utilisation à la production d'un composant électronique, comprenant :
une partie cadre extérieur (12) comportant une ouverture centrale qui y est formée et définissant des côtés intérieurs de la partie cadre extérieur ;
une partie de montage (16) pour y monter un élément électronique, supporté par ladite partie cadre extérieur et disposé à l'intérieur de son ouverture centrale, les côtés extérieurs de la partie de montage étant dans une disposition espacée par rapport aux côtés intérieurs correspondants de ladite partie cadre extérieur ;
au moins un groupement d'éléments conducteurs (22₁, 22₂, 22₃, 22₄) comprenant plusieurs éléments conducteurs, disposés le long de l'un, associé, desdits côtés extérieurs de ladite partie de montage et un élément barre de raccordement commun (24) associé avec chacun desdits groupements d'éléments conducteurs, ledit élément barre de raccordement commun étant intégré aux éléments conducteurs dudit groupement d'éléments conducteurs et connectant ainsi ensemble la totalité desdits éléments conducteurs de celui-ci ; et
dans lequel au moins deux éléments barres de raccordement extensibles (26) sont prévus pour chaque groupement d'éléments conducteurs (22₁, 22₂, 22₃, 22₄) et sont disposés de manière symétrique par rapport au centre de chaque groupement d'éléments conducteurs, lesdits éléments barres de raccordement extensibles (26) associés à chacun desdits groupements d'éléments conducteurs, s'étendant entre et interconnectant ladite partie cadre extérieur et ledit groupement d'éléments conducteurs associé pour supporter ainsi ledit groupement d'éléments conducteurs sur ladite partie cadre, chaque élément barre de raccordement extensible (26) étant connecté, à l'une de ses extrémités, à la ladite partie cadre extérieur (12) et, à son autre extrémité, audit groupement d'éléments conducteurs associé, et incluant une partie profilée qui peut être étirée par sa déformation ;
caractérisée en ce que ladite partie profilée de chaque élément barre de raccordement extensible (26) est pourvue d'une partie en double U retourné de façon à être extensible dans une direction, et dans une certaine mesure, en permettant un coudage des éléments conducteurs tel qu'après coudage, les extrémités extérieures des éléments conducteurs s'étendent dans un plan différent du plan principal de la grille de connexion, mais parallèlement à celui-ci, sans détacher les éléments conducteurs de ladite partie cadre extérieur (12).

2. Procédé de production d'un composant électronique en utilisant une grille de connexion (10) selon la revendication 1, comprenant les étapes :
de montage d'un élément électronique (30) sur la partie de montage (16) de ladite grille de connexion (10) ;
d'établissement de connexions électriques entre des bornes respectives sur l'élément électronique (30) monté et les extrémités intérieures d'éléments conducteurs dudit groupement d'éléments conducteurs (22₁, 22₂, 22₃, 22₄) ;
d'enrobage, à l'aide d'une matière appropriée, de la partie de montage (16) de ladite grille de connexion, de l'élément électronique (30) qui y est monté, et des extrémités intérieures des éléments conducteurs dudit groupement d'éléments conducteurs ;
de coudage des parties extérieures des éléments conducteurs, qui s'étendent à partir de la partie enrobée dudit groupement d'éléments conducteurs, hors du plan principal de la grille de connexion, en utilisant une presse, la partie profilée de chaque élément barre de raccordement extensible (26) s'étirant pour maintenir la connexion entre le groupement d'éléments conducteurs et ladite partie cadre extérieur ;
d'exécution d'un traitement de placage électrolytique pour revêtir les éléments conducteurs coudés de ladite grille de connexion à l'aide d'une couche d'alliage appropriée, par application d'un courant électrique aux éléments conducteurs coudés dudit groupement d'éléments conducteurs, par l'intermédiaire de chaque élément barre de raccordement étiré (26) ; et
de mise à longueur des éléments conducteurs coudés et plaqués dudit groupement d'éléments conducteurs.

3. Procédé selon la revendication 2, dans lequel ladite étape de coudage s'effectue avant l'étape de montage, lesdites parties extérieures desdits éléments conducteurs étant des parties destinées à s'étendre depuis la partie enrobée du groupement d'éléments conducteurs après ladite étape d'enrobage.

## Patentansprüche

1. Leiterrahmen (10) zur Verwendung bei der Produktion einer elektrischen Komponente, umfassend:
einen äußeren Rahmenabschnitt (12) mit einer zentralen Öffnung, die darin ausgebildet ist, und innere Seiten des äußeren Rahmenabschnittes definiert;
einen Montageabschnitt (16) zum Montieren eines elektronischen Elementes darauf, welcher von dem äußeren Rahmenabschnitt gehalten wird und innerhalb der zentralen Öffnung desselben mit den äußeren Seiten des Montageabschnittes im Abstand von den zugeordneten inneren Seiten des äußeren Rahmenabschnittes angeordnet ist;
wenigstens ein Leiterelement-Array (22₁, 22₂, 22₃, 22₄), umfassend mehrere entlang einer zugeordneten äußeren Seiten des Montageabschnittes angeordnete Leiterelemente und jeweils ein jedem dieser Leiterelement-Arrays zugeordnetes gemeinsames Verbindungsstabelement (24), wobei dieses gemeinsame Verbindungsstabelement mit den mehreren Leiterelementen dieses Leiterelement-Arrays integriert ist und dadurch alle dieser mehreren Leiterelemente desselben miteinander verbindet; und
wenigstens zwei dieser dehnbaren Verbindungsstabelemente (26) sind für jedes Leiterelement-Array (22₁, 22₂, 22₃, 22₄) vorgesehen und bezüglich des Zentrums eines jeden Leiterelement-Arrays symmetrisch angeordnet, wobei diese jedem der Leiterelement-Arrays zugeordneten dehnbaren Verbindungsstabelemente (26) sich zwischen dem äußeren Rahmenabschnitt und dem zugeordneten Leiterelement-Array erstrecken und diese miteinander verbinden, um dadurch das Leiterelement-Array an dem äußeren Rahmenabschnitt zu halten, wobei jedes dehnbare Verbindungsstabelement (26) über ein Ende desselben mit dem äußeren Rahmenabschnitt (12) und über das andere Ende desselben mit dem zugeordneten Leiterelement-Array verbunden ist und einen geformten Abschnitt umfaßt, welcher durch Verformung desselben gedehnt werden kann, dadurch **gekennzeichnet,** daß dieser geformte Abschnitt eines jeden dehnbaren Verbindungsstabelementes (26) mit einem doppelten U-Bogenabschnitt so versehen ist, daß dieser in einer Richtung dehnbar ist und bis zu einem gewissen Grad eine solche Verbiegung der Leiterelemente erlaubt, daß nach dem Biegen die äußeren Enden der Leiterelemente sich in einer Ebene erstrecken, die von der Hauptebene des Leiterrahmens verschieden, jedoch zu dieser parallel ist, ohne die Leiterelemente von diesem äußeren Rahmenabschnitt (12) zu lösen.

2. Verfahren zum Produzieren einer elektronischen Komponente unter Verwendung eines Leiterrahmens (10) gemäß Anspruch 1, umfassend die Schritte:
Montieren eines elektronischen Elementes (30) auf dem Montageabschnitt (16) dieses Leiterrahmens (10);
Herstellen elektrischer Verbindungen zwischen jeweiligen Anschlüssen an dem montierten elektronischen Element (30) und den inneren Enden von Leiterelementen dieses Leiterelement-Arrays (22₁, 22₂, 22₃, 22₄);
Verkapseln des Montageabschnittes (16) dieses Leiterrahmens, des darauf montierten elektronischen Elementes (30) und der inneren Enden der Leiterelemente dieses Leiterelement-Arrays mit einem geeigneten Material;
Biegen der äußeren Abschnitte der Leiterelemente, welche sich von dem verkapselten Abschnitt dieses Leiterelement-Arrays aus erstrecken, aus der Hauptebene des Leiterrahmens heraus unter Verwendung einer Presse, wobei der geformte Abschnitt eines jeden dehnbaren Verbindungsstabelementes (26) gedehnt wird, um die Verbindung zwischen dem Leiterelement-Array und diesem äußeren Rahmenabschnitt aufrechtzuerhalten;
Ausführen eines elektrolytischen Prozesses, um die gebogenen Leiterelemente des Leiterrahmens mit einer geeigneten Legierungsschicht zu bedecken, indem ein elektrischer Strom unter Zwischenschaltung der jeweiligen gedehnten Verbindungsstabelemente (26) an die gebogenen Leiterelemente in diesem Leiterelement-Array angelegt wird;
und Trimmen der gebogenen und plattierten Leiterelemente des Leiterelement-Arrays.

3. Verfahren nach Anspruch 2, bei welchem der Biegeschritt vor dem Montageschritt ausgeführt wird, wobei die äußeren Abschnitte der Leiterelemente Abschnitte sind, die aus dem verkapselten Abschnitt des Leiterelement-Arrays nach dem Verkapselungsschritt herausragen sollen.
